(19) Europäisches Patentamt

European Patent Office

Office européen des brevets

(11) **EP 1 456 956 B1**

(12) **EUROPÄISCHE PATENTSCHRIFT**

(45) Veröffentlichungstag und Bekanntmachung des Hinweises auf die Patenterteilung:
**26.10.2005 Patentblatt 2005/43**

(21) Anmeldenummer: 02795244.9

(22) Anmeldetag: **19.12.2002**

(51) Int Cl.⁷: **H03M 3/04**

(86) Internationale Anmeldenummer:
**PCT/EP2002/014597**

(87) Internationale Veröffentlichungsnummer:
**WO 2003/052938 (26.06.2003 Gazette 2003/26)**

(54) **SIGMA-DELTA-WANDLER MIT RAUSCHUNTERDRÜCKUNG**

SIGMA-DELTA CONVERTER COMPRISING NOISE SUPPRESSION

CONVERTISSEUR SIGMA-DELTA A ELIMINATION DES BRUITS PARASITES

(84) Benannte Vertragsstaaten:
**DE FR GB**

(30) Priorität: **19.12.2001 EP 01130333**

(43) Veröffentlichungstag der Anmeldung:
**15.09.2004 Patentblatt 2004/38**

(73) Patentinhaber: **SIEMENS AKTIENGESELLSCHAFT**
**80333 München (DE)**

(72) Erfinder: **JELONNEK, Björn**
**89079 Ulm (DE)**

(56) Entgegenhaltungen:
**WO-A-98/48515**

**Beschreibung**

Die Erfindung betrifft einen Sigma-Delta-Wandler zur Wandlung eines digitalen Eingangssignals in ein analoges Ausgangssignal, nach dem Oberbegriff des Anspruchs 1.

In Digital-zu-Analog-Wandlern, wie sie zum Beispiel in digitalen Funkkommunikations-Empfangseinrichtungen eingesetzt werden, wird üblicherweise ein digitales Eingangssignal mit $2^N$ Signalzuständen und einer festen Abtastfrequenz $f_a$ in ein analoges Signal überführt, dass im Frequenzbereich $-f_a/2$ bis $+f_a/2$ möglichst gut mit dem digitalen Signal übereinstimmen soll.

Insbesondere bei hohen Bitbreiten N stellt die durch analoge Schaltungstechnik zu realisierende Anzahl von Signalzuständen ein wesentliches Problem dar, da die $2^N$ Signalzustände mit steigender Anzahl immer schwerer aus dem Quantisierungsrauschen zu diskriminieren sind. Aus diesem Grund wird das digitale Signal durch digitale Filter interpoliert und es werden sogenannte Sigma-Delta-Modulatoren eingesetzt, die die Bitbreite des digitalen Signals bei erhöhter Abtastfrequenz deutlich reduzieren und das dadurch erhöhte Quantisierungsrauschen in bisher ungenutzte Frequenzbereiche transformieren. Besonders effizient sind hierbei Strukturen von Sigma-Delta-Modulatoren, die eine Formung des Rauschsignals wie durch IIR-Filter (Infinite-Impulse-Response-Filter) höherer Ordnung erzielen. Den Sigma-Delta-Modulatoren sind Digital-zu-Analog-Wandler nachgeschaltet, die das digitale Ausgangssignal der Sigma-Delta-Modulatoren in ein analoges Signal umsetzen. Sigma-Delta-Modulatoren und Digital-zu-Analog-Wandler ergeben zusammen den sogenannten Sigma-Delta-Wandler.

Um eine Rauschformung bei Sigma-Delta-Modulatoren zu erreichen, existieren zwei Ansätze:

Nach einem ersten Ansatz werden Rückkoppelschleifen höher Ordnung eingesetzt, welche eine Reduktion der Stufenzahl auf bis zu zwei Signalzustände erlauben. Nachteilig wirkt sich aus, dass die Rauschformung ab der Ordnung 3 bei hohen Eingangssignalen zu möglichen Instabilitäten führt.

Nach einem zweiten Ansatz werden kaskadierte Strukturen erster und/oder zweiter Ordnung eingesetzt, die mehrstufig sind und dadurch ein stabiles Betriebsverhalten ausweisen.

Eine ausführliche Darstellung des Aufbaus und der Wirkungsweise von Sigma-Delta-Modulatoren wird S.R. Norswothy, R. Schreier, G. Temes: "Delta-Sigma Converters, Theorie, Design und Simulation", IEEE Press 1997, ISBN 0-7803-1045-4 gegeben.

Eine spezielle kaskadierte Struktur eines Sigma-Delta-Modulators ist in der DE 199 37 246 beschrieben. Durch diese kaskadierte Struktur wird zum einen die Anzahl von Signalzuständen reduziert und zum anderen bleibt auch bei Sigma-Delta-Modulatoren höherer Ordnung die Stabilität weitgehend garantiert.

Sigma-Delta-Wandler, deren Anzahl an Signalzuständen bis auf zwei reduziert wurde, bieten für die Realisierung des Digialzu-Analog-Wandlers wesentliche Vorteile. Variationen in der Signalamplitude oder eines möglichen Gleichspannungsanteils in dem Signal beeinflussen die Linearität des analogen Ausgangssignals nicht. Nachteilig ist jedoch der notwendige hohe Überabtastfaktor (Verhältnis Nutzbandbreite zu Abtastrate des Sigma-Delta-Wandlers), auf den das Basisbandsignal interpoliert werden muss, damit ein bestimmtes Signal-zu-Rausch-Verhältnis in Nutzband gewährleistet werden kann.

Werden statt zweistufigen mehrstufige Sigma-Delta-Wandler verwendet, so können theoretisch deutlich kleinere Überabtastfaktoren verwendet werden. Typischerweise sind dafür viele Quantisierungsstufen erforderlich, die alle identisch hoch sein müssen, damit das Quantisierungsrauschen optimiert ist. Wie bspw. in "Delta-Sigma-Data-Converters, Theorie, Design and Simulation", 1996 von S. R. Norswothy, R. Schreier und G. Temes beschrieben, wird dieses Problem dadurch gelöst, das eine Vielzahl von zweistufigen Digital-zu-Analog-Wandlern eingesetzt werden. Durch einen speziellen Verwürfelungsalgorithmus nach dem eigentlichen Sigma-Delta-Wandler wird sichergestellt, dass der Datenstrom jedes einzelnen Sigma-Delta-Wandlers rauschgeformt ist und im Nutzsignalband wenige Störungen verursacht (noise shaped element usage). Die Stabilität des Algorithmus ist ab zweiter Ordnung nicht sichergestellt. Sein Aufwand ist wegen dem hier verwendeten Vektorquantisierers relativ hoch. Weiterhin ist die Struktur dieses Verwürfungsalgorithmus nicht linear und rückkoppelt, was einer direkten Parallelisierung entgegensteht.

Der vorliegenden Erfindung liegt daher die Aufgabe zugrunde, für einen Sigma-Delta-Wandler eine Struktur zu finden, die bei gegebenem geringem Überabtastfaktor mit hohem Signal-zu-Rausch-Verhältnis (SNR) nur wenige zweistufige Sigma-Delta-Wandler erfordert, wobei die Struktur der Sigma-Delta-Wandler parallelisierbar sein soll.

Diese Aufgabe wird durch einen Sigma-Delta-Wandler mit den Merkmalen nach Anspruch 1 gelöst. Ausgestaltungen und Weiterbildungen der Erfindung sind Gegenstand der Unteransprüche.

Erfindungsgemäß ist jeder Parallel-Pfad derart ausgebildet, dass das Eingangssignal des Sigma-Delta-Modulators des Parallel-Pfades das mindestens um die Rauschanteile außerhalb des Nutzbandes gefilterte Differenzsignal aus dem digitalen Ausgangssignals des Sigma-Delta-Modulators des Haupt-Pfades und aus dem entsprechend der Übertragungsfunktion des Sigma-Delta-Modulators des Haupt-Pfades durch einen Filter spektral geformten Eingangssignals x(k) ist.

Durch die spektrale Formung des Eingangssignals x(k) entsprechend der Übertragungsfunktion des Sigma-Delta-Modulators des Haupt-Pfades und der anschließenden Differenzbildung mit dem digitalen Ausgangssignals des Sigma-Delta-Modulators werden im wesentlichen die Quantisierungsfehler des Sigma-Delta-Modulators des Haupt-Pfades isoliert. Durch die anschließende Filterung werden dann die Rauschanteile außerhalb des Nutzbandes, welche die wesentlichen Anteile der Rauschleistung darstellen, gedämpft. Durch diese Stuktur eines Sigma-Delta-Wandlers werden die Signalanteile des Haupt- und Parallel-Pfades konstruktiv überlagert, während sich die Rauschanteile beider Pfade destruktiv überlagern. Dadurch kann das Quantisierungsrauschen der Sigma-Delta-Wandler zu mindestens teilweise kompensiert werden. Diese Parallelschaltung kommt ohne Rückkoppelpfade aus.

In Weiterbildung der Erfindung ist der mindestens eine Parallel-Pfad derart ausgebildet, dass Mittel zur Verstärkung des digitalen Signals unmittelbar vor dem Sigma-Delta-Modulator vorgesehen sind. Sind die wesentlichen Anteile der Rauschleistung unterdrückt, so kann die Amplitude des Signals angehoben werden, ohne dass der Sigma-Delta-Modulator übersteuert wird.

In Weiterbildung der Erfindung ist mindestens ein Parallel-Pfad derart ausgebildet, dass Mittel zur Dämpfung des gewandelten Signals nach dem Mittel zur Digital-zu-Analog-Wandlung des modulierten Signals und vor der Bildung des Summensignals vorgesehen sind. Die Dämpfung des analogen Signals orientiert sich an der vorhergehenden digitalen Verstärkung. Rauschsignalkomponenten im analogen Ausgangssignal des Digital-zu-Analog-Wandlers des Haupt-Pfades werden somit kompensiert. Statt einer expliziten Dämpfung des analogen Signals kann alternativ ein Digital-zu-Analog-Wandler mit geringerer Ausgangsleistung eingesetzt werden.

In Weiterbildung der Erfindung ist mindestens ein Parallel-Pfad derart ausgebildet, dass Mittel zur zeitlichen Verzögerung des Eingangssignals $x(k)$ zum Ausgleich von Laufzeitunterschieden zum Haupt-Pfad vorhanden sind. Laufzeitunterschiede können insbesondere durch unterschiedliche Verarbeitungszeiten digitaler Komponenten wie Filter, Sigma-Delta-Modulatoren oder dergleichen auftreten. Durch die Verzögerungsglieder werden die Laufzeiten in den einzelnen Kaskadestufen kompensiert.

In Weiterbildung der Erfindung ist der Hauptpfad derart ausgebildet, dass nach der Abzweigung zum Parallel-Pfad und vor dem Mittel zur Digital-zu-Analog-Wandlung Mittel zur Kompensationsfilterung vorgesehen sind. Durch das Mittel zur Kompensationsfilterung im Hauptpfad können die Laufzeiten und die Frequenzgänge des Parallelpfades, welcher Filter, Verstärker und Sigma-Delta-Wandler umfasst, kompensiert werden. Durch diesen zusätzlichen Filter können Fehleranteile des Parallel-Pfades kompensiert werden.

Mit Vorteil ist der Sigma-Delta-Wandler des Haupt-Pfades als ein mehrstufiger Sigma-Delta-Wandler ausgebildet. In mehrstufigen Sigma-Delta-Wandlern kann das Prinzip der Weitergabe des Quantisierungsrauschens ausgenutzt werden, so dass sich das Quantisierungsrauschen der einzelnen Stufen destruktiv überlagert, das heißt, dass der Rauschanteil des gesamtem Sigma-Delta-Wandlers nicht direkt proportional mit der Stufenzahl des mehrstufigen Sigma-Delta-Wandlers zunimmt, sondern geringer als proportional. Desweiteren ist es möglich, durch die Verwendung mehrstufiger Sigma-Delta-Wandler unterschiedliche Eigenschaften in unterschiedlichen Stufen zu kombinieren.

Ist der mehrstufige Sigma-Delta-Wandler des Haupt-Pfades durch den Haupt-Pfad und mindestens eine Kaskadestufe ausgebildet, wobei jede Kaskadestufe ein Parallel-Pfad ist, so können besonders vorteilhaft das Quantisierungsrauschen der einzelnen Kaskadestufen kompensiert werden.

In Weiterbildung der Erfindung ist für $n > 1$ Kaskadestufen jeder Kaskadestufe $i$ mit $2 \leq i \leq n$, die Kaskadestufe $i-1$ derart parallel geschaltet ist, so dass die Kaskadestufe $i-1$ für die Kaskadestufe $i$ die Funktion des Haupt-Pfades übernimmt, wobei dem Eingangssignal des Sigma-Delta-Modulators jeder Kaskadestufe zusätzlich ein dem Hauptpfad durch Zeitverzögerung angepaßtes Eingangssignal $x(k)$ aufaddiert ist, wobei dem Eingangssignal des Sigma-Delta-Modulators der Kaskadestufe $i$ zusätzlich das rauschgefilterte Signal der Kaskadestufe $i-1$ aufaddiert ist, wobei das digitale Ausgangssignal zur Differenzbildung des mehrstufigen Sigma-Delta-Modulators das Summensignal der Ausgangssignale aller Sigma-Delta-Modulatoren des mehrstufigen Sigma-Delta-Modulators ist. Durch diese Struktur eines mehrstufigen Sigma-Delta-Wandlers kompensieren sich die In-Band Rauschsignalanteile aller Sigma-Delta-Modulatoren bis auf die der letzten Kaskadestufe. Im Nutzband verbleibt nur das Quantisierungsrauschen des Sigma-Delta-Modulators der letzten Kakadestufe und das sich konstruktiv überlagernde Summensignal aller Signalanteile.

Mit Vorteil besitzt der mehrstufige Sigma-Delta-Modulator des Haupt-Pfades Sigma-Delta-Modulatoren mit linearphasigen Frequenzgängen mit Betragsfrequenzgang eins. In der Regel kann dadurch auf eine spektrale Rauschformung des Nutzsignals verzichtet werden, da dieses im Fall von linearphasigen Frequenzgängen mit Betragsfrequenzgang eins (d.h. keine Verstärkung oder Dämpfung) üblicherweise schon bandbegrenzt ist.

In Weiterbildung ist der mehrstufige Sigma-Delta-Wandler derart ausgebildet, dass eine Anzahl $n > 1$ Sigma-Delta-Wandler kaskadeartig parallel geschaltet sind, wobei das Eingangssignal des Sigma-Delta-Modulators der Kaskadestufe $n$ das Differenzsignal aus dem Eingangssignal $x(k)$ und dem rauschgefilterten und mit $n$ normierten Summensignal der Ausgangssignale der Sigma-Delta-Modulatoren des Hauptpfades und der Kaskadestufen $i$ mit $1 < i < n-1$ ist, wobei das zur Differenzbildung verwendete digitale Ausgangssignal des mehrstufigen Sigma-Delta-Modulators des Haupt-Pfades das Summensignal aller Ausgangssignale der $n$ Sigma-Delta-Modulatoren des mehrstufigen Sigma-Delta-Modulators ist. Neben der Möglichkeit, das Eingangssignal des Sigma-Delta-Modulators der Kaskadestufe $n$ als solches zur Differenzbildung zu verwenden, besteht eine bevorzugte Möglichkeit darin, dass das Eingangssignal des Sigma-Delta-Modulators der Kaskadestufe $n$ mit der Anzahl $n$ der Kaskadestufen multipliziert ist.

Mit Vorteil sind die Sigma-Delta-Wandler als 1-Bit Sigma-Delta-Wandler ausgebildet, wobei der 1-Bit Sigma-Delta-Wandler und damit die 1-Bit Analog-zu-Digital-Wandler ungleiche Ausgangsleistungen besitzen können. Im Hinblick auf die Rauschformung des erzeugten Multibit-Sigma-Delta-Ausgangssignals erscheint diese Ausgestaltung zunächst als Nachteil, da die Sigma-Delta-Modulatoren auf die Stabilitätsgrenzen und Aussteuerungsbereich eines 1-Bit-Sigma-Delta-Modulators angewiesen sind. Unter Berücksichtigung von ungleichen Ausgangsleistungen (Mismatch) der Einzelnen 1-Bit-Digital-zu-Analog-Wandlern kehrt sich diese Bewertung jedoch in einen Vorteil um: Das In-Band-Rauschen enthält nun neben dem Rauschen des erzeugten Multibit-Sigma-Delta-Ausgangssignals auch Rauschkomponenten, die die 1-Bit Datenströme spektral formt und sich entsprechend der Ausgangssignalleistungsunterschiede der einzelnen Digital-zu-Analog-Wandler in das In-Band-Rauschen mit eingehen. Man benötigt nun mit der vorgestellten Struktur keinen nachgestellten Algorithmus, der aus dem Multibit-Signal mehrere 1-Bit Datenströme erzeugt und der aufgrund der Restriktion, ein Multibitsignal wiederzugeben, für jeden dieser einzelnen Datenströme nur eine suboptimale Rauschformung erzielt. Jedes einzelne 1-Bit Datensignal ist optimal spektral geformt und garantiert bei hohen Fehlanpassungen ein geringes In-Band-Rauschen. Durch das oben beschriebene Prinzip der Rauschsignalunterdrückung kann nun der wesentliche Nachteil des Sigma-Delta-Modulators - die reduzierte In-Band-Rauschsignalformung - erheblich über das durch einen bis bisher verwendeten Multibit-Sigma-Delta-Analog-zu-Analog-Wandler erreichbare Maß hin verbessert werden.

In Weiterbildung der Erfindung sind die Rauschsignale der Sigma-Delta-Modulatoren des mehrstufigen Sigma-Delta-Modulatores unkorreliert. Zusätzlich können den Eingangssignalen der Sigma-Delta-Modulatoren des mehrstufigen Sigma-Delta-Modulators unkorrelierte stochastische Signale aufaddiert werden. Dadurch können bei bestimmten Signalen im Nutzband auftretende Störlinien, in denen sich die Rauschleistung der näheren Umgebung konzentriert, kompensiert werden. Um diesen Effekt weitgehend zu unterdrücken, wird Sigma-Delta-Modulatoren "Dither" hinzugefügt ("Dither" ist ein mit dem Eingangssignal des Sigma-Delta-Wandlers unkorreliertes stochastisches Signal), das entweder auf das Eingangssignal des Sigma-Delta-Modulators addiert wird oder den Eingang auf die Entscheidung des Sigma-Delta-Modulators direkt findet. Normalerweise reduziert der "Dither" die Störlinien auf Kosten des erreichbaren Signal-Rauscheverhältnisses des Modulators und wird deshalb in der Amplitude stark begrenzt.

Im Hinblick auf eine kostengünstige und technisch flexible Herstellungsart kann der Sigma-Delta-Wandler in CMOS-Technik (Complementary Metal-Oxide-Silicon) hergestellt sein.

Der erfindungsgemäße Sigma-Delta-Wandler eignet sich hervorragend zur Verwendung in einem Funkkommunikationssystem und dort insbesondere in Funkkommunikations-Empfangseinrichtungen.

Die Erfindung wird im folgenden an Hand von Ausführungsbeispielen näher erläutert.

Hierbei zeigen:

Fig. 1: Das Grundprinzip eines erfindungsgemäßen Sigma-Delta-Wandlers mit Rauschunterdrückung,

Fig. 2: ein Sigma-Delta-Wandler mit Raschsignalunterdrückung mit einem mehrstufugen Sigma-Delta-Wandler im Haupt-Pfad (drei kaskadierte Sigma-Delta-Modulatoren) nach einer Ausgestaltung der Erfindung,

Fig. 3: ein Sigma-Delta-Wandler mit Rauschsignalunterdrückung mit Sigma-Delta-Modulatoren mit linearphasigem Filterfrequenzbereich nach einer anderen Ausgestaltung der Erfindung,

Fig. 4: ein Sigma-Delta-Wandler mit Rauschsignalunterdrückung nach einer weiteren Ausgestaltung der Erfindung, wobei den Eingangssignalen der Haupt- und Parallel-Pfade unkorrelierte und stochastische Signale aufaddiert sind.

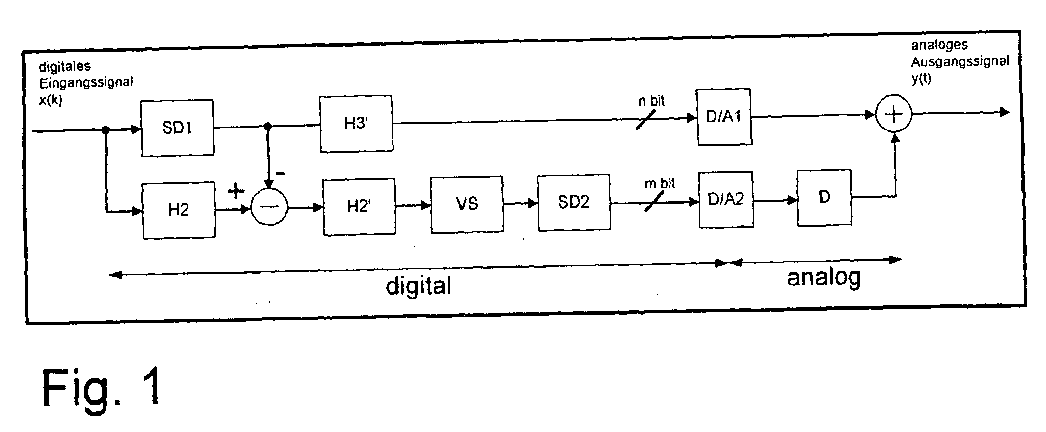

In Fig. 1 wird das Grundprinzip eines Sigma-Delta-Wandlers mit Rauschunterdrückung dargestellt. Ein erster Sigma-Delta-Modulator SD1 im Haupt-Pfad erzeugt aus einem digitalen Eingangssignal x(k) ein digitales Ausgangssignal mit auf n-Bit eingeschränkter Bitbreite. Aufgrund dieser eingeschränkten Bitbreite entsteht ein Quantisierungsfehler, der durch den Sigma-Delta-Algorithmus entsprechend seiner Rauschübertragungsfunktion außerhalb des Nutzbandes transformiert wird. Insbesondere bei einem geringen Überabtastfaktor fallen jedoch auch signifikante Rauschsignalkomponenten in das Nutzband. Um diese zu unterdrücken wird erfindungsgemäß das digitale Eingangssignal x(k) entsprechend der Signalübertragungsfunktion des ersten Sigma-Delta-Wandlers SD1 mittels eines Filters H2 spektral geformt. Danach wird das Ausgangssignal des ersten Sigma-Delta-Wandlers von dem gefilterten Eingangssignal abgezogen, so das vom Quantisierungsfehler des Sigma-Delta-Modulators SD1 erzeugte Rauschsignal bestimmt. Durch einen weiteren Filter H2' werden die Rauschsignalanteile außerhalb des Nutzbandes gedämpft. Da diese den wesentlichen Anteil der Rauschleistung enthalten, kann das Ausgangssignal des Filters H2' in der Amplitude angehoben werden VS, ohne dass der nachfolgende Sigma-Delta-Modulator SD2 übersteuert wird. Damit ist das durch den Sigma-Delta-Modulator SD2 mit der Begrenzung auf m-Bit eingebrachte zusätzliche Rauschen in der Amplitude geringer als das verstärkte Rauschsignal des Sigma-Delta-Modulators SD1. Nach der Digital-zu-Analog Wandlung D/A2 wird das analoge Rauschsignal entsprechend seiner vorhergehend digitalen Verstärkung analog gedämpft D und kompensiert dann die Rauschsignalkomponente im analogen Ausgangssignal des Digital-zu-Analog-Wandlers D/A1. Statt einer expliziten Dämpfung kann stattdessen ein Digial-zu-Wandler mit geringer Ausgangsleistung eingesetzt werden.

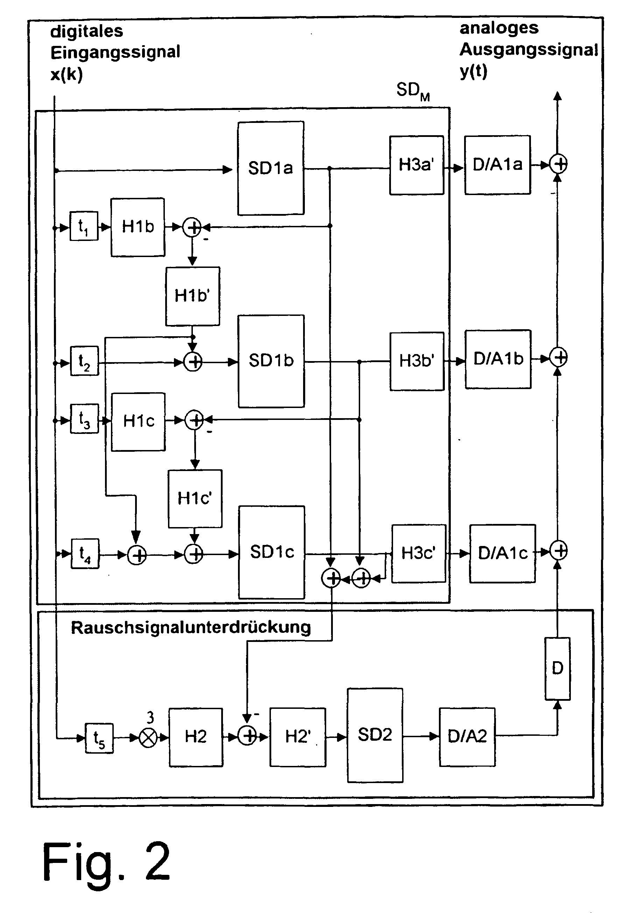

Das in Fig. 1 dargestellte Grundprinzip der Weitergabe des Quantisierungsrauschen an einen weiteren Sigma-Delta-Modulator kann auch für den Aufbau mehrstufiger Sigma-Delta-Wandler verwendet werden. Als Anwendungsbeispiel ist der Sigma-Delta-Modulator SD1 aus Fig. 1 in Fig. 2 durch drei niederstufige Sigma-Delta-Modulatoren SD1a, SD1b, SD1c realisiert. Dabei wird das In-Band-Quantisierungsrauschen des Sigma-Delta-Modulators SD1a berechnet und negiert auf das digitale Eingangssignal des Sigma-Delta-Modulators SD1b addiert. Das gemeinsame Rauschsignal dieser beiden Sigma-Delta-Modulatoren wird dann berechnet und dann auf das Eingangssignal des Sigma-Delta-Modulators SD1c addiert. Verzögerungsglieder t1, t2, t3, t4, t5 werden eingesetzt, um die Laufzeit der Sigma-Delta-Modulatoren oder Filter zu kompensieren. Dieses Vorgehen ist beliebig auf mehr Sigma-Delta Modulatoren erweiterbar und ist in Fig. 2 nur beispielhaft auf drei Modulatoren beschränkt.

Fügt man alle drei Ausgangssignale der Sigma-Delta-Modulatoren zusammen, so kompensieren sich die In-Band Rauschsignalanteile der ersten beiden Sigma-Delta-Modulatoren mit den entsprechenden Eingangssignalkomponenten des zweiten und dritten Sigma-Delta-Modulators. Es verbleibt im Nutzband nur das Quantisierungsrauschen des dritten Sigma-Delta-Modulators, wohingegen sich alle drei Signalanteile x(k) konstruktiv überlagern.

In Hinblick auf die Rauschformung des erzeugten Multibit-Sigma-Delta Ausgangssignals erweist sich dieses Vorgehen zunächst als nachteilig; man ist bei dem Sigma-Delta-Modulator auf die Stabilitätsgrenzen und den Aussteuerungsbereich beispielsweise eines 1-bit Sigma-Delta-Modulators angewiesen.

Unter Berücksichtigung von ungleichen Ausgangsleistungen der einzelnen 1-bit Digital-zu-Analog-Wandler (Fehlanpassung) kehrt sich diese Bewertung jedoch um: Das In-Band-Rauschen enthält nun neben dem Rauschen des erzeugten Multibit-Sigma-Delta Ausgangssignals auch Rauschkomponenten, die wie die 1-bit Datenströme spektral geformt sind und die entsprechend der Ausgangssignalleistungsunterschiede der einzelnen Digital-zu-Analog-Wandler in das In-Band-Rauschen mit eingehen.

Man benötigt nun erfindungsgemäß mit der vorgestellten Struktur keinen nachgeschalteten Algorithmus, der aus dem Multibit-Signal mehrere 1-bit Datenströme erzeugt und der aufgrund der Restriktion, ein vorgegebenes Multibit-Signal wiederzugeben, für jeden dieser einzelnen Datenströme nur eine suboptimale Rauschformung erzielt. Jedes einzelne 1-bit Datensignal ist optimal spektral geformt und garantiert bei hoher Fehlanpassung ein geringes In-Band-Rauschen.

Durch das oben beschriebene Prinzip einer Rauschsignalunterdrückung kann nun der wesentliche Nachteil des Sigma-Delta-Modulators - die reduzierte In-Band Rauschsignalformung - erheblich über das durch einen bisher verwendeten Multibit-Sigma-Delta-D/A-Wandler erreichbare Maß hin verbessert werden, wie es im Ausführungsbeispiel nach Fig. 2 dargestellt ist.

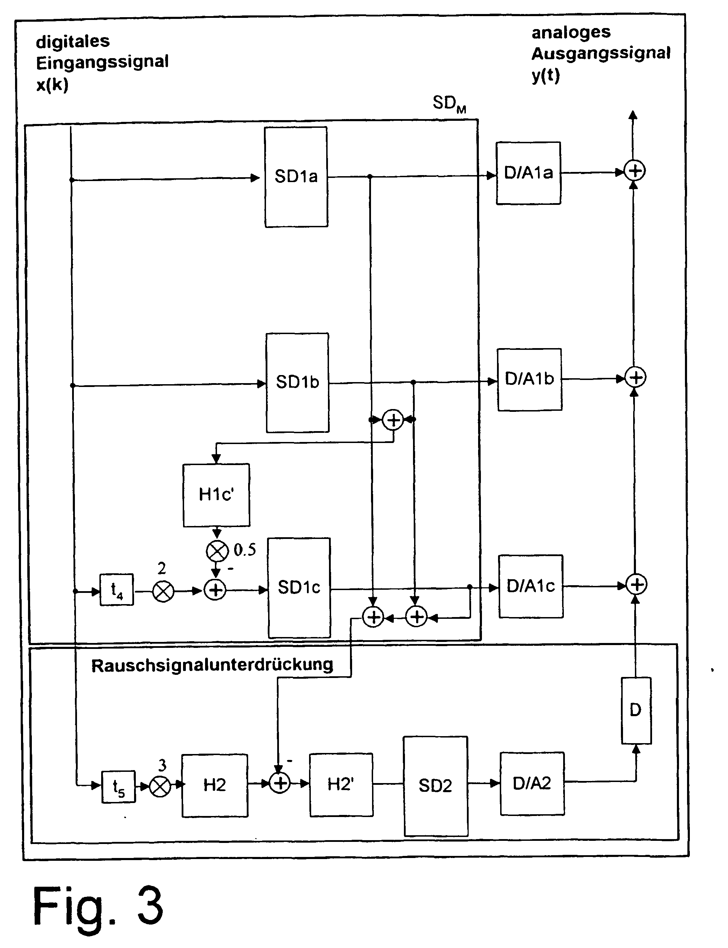

Die in Fig. 2 dargestellte Art der Weitergabe des Sigma-Delta-Rauschens im D/A-Modulator stellt nur einen Spezialfall dar. Beispielsweise kann anstelle der in Fig. 2 dargestellten Übergabe des negierten Rauschens eines Sigma-Delta-Modulators an den Eingang des nächstfolgenden das negierte Rauschen eines Sigma-Delta-Modulators auch auf mehrere Sigma-Delta-Modulatoren aufgeteilt werden, wie es in Fig. 3 gezeigt ist. Der Vorteil dieses Vorgehens liegt in der Verringerung der Rauschleistung bei der ungünstigsten Kombinationsmöglichkeit. Bezeichnet man beispielsweise das Rauschen des Sigam-Delta-Modulators SD1a mit R1a, so ist das Rauschen der einzelnen Sigma-Delta-Modulatoren aus Fig. 2 im Nutzsignalband:

| Rauschverhältnis von SD1a zu D/A1a | R1a |
|---|---|
| Rauschverhältnis von SD1b zu D/A1b | R1b-R1c |
| Rauschverhältnis von SD1c zu D/A1c | R1c-R1b |
| Rauschverhältnis von SD2 zu D/A2 | R2-R1c |

Nimmt man an, dass die einzelnen Digital-zu-Analog Wandler D/A1a, D/A1b, D/A1c, D/A2 in der Amplitude um den Betrag 1+/d schwanken, so ist im schlimmsten Fall das Vorzeichen von d positiv bei D/A1a, negativ bei D/A1b, positiv bei D/A1c und wieder negativ bei D/A2, so dass man für den Multibit-Sigma-Delta-Modulator mit Kompensation des Rauschens das gesamte Ausgangssignalrauschen

$$(1+d)*R1a+(1-d)*(R1b-R1a)+(1+d)*(R1c-R1b)+(1-d)*(R1c+R2)=$$

$$=R2+2*d*(R1a-R1b+R1c)$$

erhält. Der erste Term R2 entspricht der angestrebten Rauschformung und ist entsprechend der gewählten Verstärkung in der Amplitude stark abgesenkt. Da die Rauschsignale der einzelnen Sigma-Delta-Modulatoren unabhängig voneinander sind, addieren sich ihre Leistungen linear. Man erhält also bei gleicher Rauschleistung der Modulatoren als Gesamt-In-Band-Rauschleistung $E\{R2*R2\}+12*E\{R1a*R1a\}$, wobei $E\{\}$ den Erwartungswert bezeichnet. Diese Rauschleistung liegt ca. 6dB über der Rauschleistung von drei voneinander unabhängig arbeitenden Sigma-Delta-Modulatoren.

Alternativen stellen

| | |
|---|---|
| Rauschverhältnis von SD1a zu D/A1a | R1a |
| Rauschverhältnis von SD1b zu D/A1b | R1b-0.5*R1a |
| Rauschverhältnis von SD1c zu D/A1c | R1c-0.5*R1a-R1b |
| Rauschverhältnis von SD2 zu D/A2 | R2-R1c |

mit einer Gesamtrauschleistung von

$$E\{R2*R2\}*(1+d)+9*E\{R1a*R1a\}$$

und

| | |
|---|---|
| Rauschverhältnis von SD1a zu D/A1a | R1a |
| Rauschverhältnis von SD1b zu D/A1b | R1b |
| Rauschverhältnis von SD1c zu D/A1c | R1c-0.5*R1a-0.5*R1b |
| Rauschverhältnis von SD2 zu D/A2 | R2 -0.5*R1a-0.5*R1b -R1c |

mit einer Gesamtrauschleistung von

$$E\{R2*R2\}*(1+d)+8*E\{R1a*R1a\}$$

dar.

Die letztgenannte Variation ist in Fig. 3 dargestellt. Es wird hier auch verdeutlicht, dass bei einem linearphasigen Filterfrequenzgang mit Betragsfrequenzgang 1 im Durchlassbereich in der Regel auf eine Filterung des Nutzsignals verzichtet werden kann, da dieses normalerweise schon bandbegrenzt ist. Nachteilig ist allerdings bei dieser Version, dass der Eingangspegel des SD2 anwächst und so, um eine Übersteuerung des Sigma-Delta-Modulators zu vermeiden, der Gewinn der Rauschkompensation ohne Fehlanpassung geringer ausfällt.

Die Struktur eines Sigma-Delta-Modulators bietet noch einen weiteren Vorteil. Die Leistung des Störsignals, dass bisher als Sigma-Delta-Rauschen bezeichnet wurde, ist in der Regel nicht spektral geformt und gleichmäßig über den Frequenzbereich verteilt. Es treten bei bestimmten Signalen im Frequenzbereich Störlinien auf, in denen sich die Rauschleistung der näheren Umgebung konzentriert. Um diesen Effekt weitgehend zu unterdrücken, wird Sigma-Delta-Modulatoren SD1a, SD1b, SD1c "Dither" DI1a, DI1b, DI1c hinzugefügt ("Dither" ist ein stochastisches Signal), das entweder auf das Eingangssignal des Sigma-Delta-Modulators addiert wird oder den Eingang auf die Entscheidung des Sigma-Delta-Modulators direkt findet. Normalerweise reduziert der "Dither" die Störlinien auf Kosten des erreichbaren Signal-Rauscheverhältnisses des Modulators und wird deshalb in der Amplitude stark begrenzt.

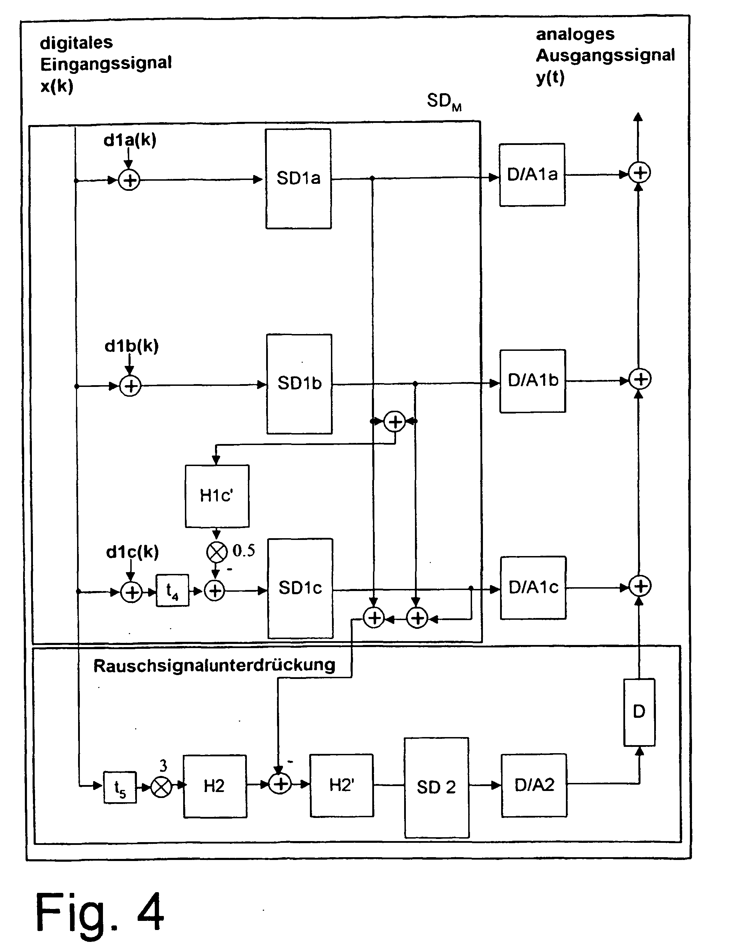

Durch die mehreren verkoppelten Modulatoren des kompensierenden Sigma-Delta-Modulators kann man nun den Störeinfluss des "Dithers" sich gegenseitig kompensieren lassen. Dies ist in Fig. 4 anhand des Spezialfalles aus Fig. 3 beispielhaft dargestellt. Den drei Sigma-Delta-Modulatoren SD1a, SD1b und SD1c werden zu dem jeweiligen Eingangssignal unterschiedliche "Dither"-Signale hinzugefügt. Wesentlich ist jetzt, dass sich die Summe aller "Dither"-Signale aufhebt, d.h. dass in dem zu erzeugenden Multibit-Signal keine Signalkomponenten des "Dithers" mehr vorhanden sind.

Ein Anwendungsbeispiel für Dither" ist

$$DI1b(k)= -0.5*DI1a(k), DI1c(k)=0.$$

Durch die spezielle Filteranordnung kompensiert SD1b die Hälfte des Dithers DI1c von SD1a, der Rest wird durch SD1c kompensiert. Problematisch ist hierbei jedoch das Verhalten bei Fehlanpassung der einzelnen Digital-zu-Analog-Wandler. Im schlechtestmöglichen Fall (Abweichung +d, -d, -d) ist der Störeinfluss der Leistung des "Dithers" (16/9) höher als die von drei unkorrelierten "Dither"-Signalen.

Die Generation solcher "Dither"-Signale kann folgendermaßen erreicht werden:

1. Es werden drei voneinander statistisch unabhängige Zufallssignale generiert DI1a(k), DI1b(k), DI1c(k).
2. Die einzelnen Signale werden derart aufgeteilt, dass jeder Sigma-Delta-Modulator als "Dither" die Summe von jeweils eines Zufallssignals positiven und zwei negativen, mit dem Faktor 0.5 multiplizierten Zufallszahlen erhält.

Aufgrund der in Fig. 4 dargestellten speziellen Struktur bedeutet dies

$$DI1a(k)= z1(k) - 0.5 \cdot z2(k) - 0.5 \cdot z3(k)$$

$$DI1b(k)= -0.5 \cdot z1(k) + z2(k) - 0.5 \cdot z3(k)$$

$$DI1c(k)=0 \ .$$

**Patentansprüche**

1. Sigma-Delta-Wandler zur Wandlung eines digitalen Eingangssignals x(k) in ein analoges Ausgangssignal y(t) mit Rauschunterdrückung innerhalb eines Nutzbandes,
   wobei der Sigma-Delta-Wandler einen Haupt-Pfad umfasst,
   wobei der Haupt-Pfad mindestens einen durch eine Übertragungsfunktion charakterisierten Sigma-Delta-Modulatulator (SD1) und einen Digital-zu-Analog Wandler (D/A1) umfasst,
   wobei dem Haupt-Pfad mindestens ein Parallel-Pfad parallel geschaltet ist,
   wobei jeder Parallel-Pfad mindestens einen Sigma-Delta-Modulatulator (SD2) und einen Digital-zu-Analog Wandler (D/A2) umfasst,
   wobei das analoge Ausgangssignal y(t) des Sigma-Delta-Wandlers das Summensignal der analogen Ausgangssignale des Haupt- und jedes Parallel-Pfades ist,
   **dadurch gekennzeichnet,**
   **dass** jeder Parallel-Pfad derart ausgebildet ist, dass das Eingangssignal des Sigma-Delta-Modulators (SD2) des Parallel-Pfades das mindestens um die Rauschanteile außerhalb des Nutzbandes gefilterte Differenzsignal aus dem digitalen Ausgangssignals des Sigma-Delta-Modulators(SD1) des Haupt-Pfades und aus dem entsprechend der Übertragungsfunktion des Sigma-Delta-Modulators (SD1) des Haupt-Pfades durch einen Filter (H2) spektral geformten Eingangssignals x(k) ist.

2. Sigma-Delta-Wandler nach Anspruch 1,
   **dadurch gekennzeichnet,**
   **dass** mindestens ein Parallel-Pfad derart ausgebildet ist, dass Mittel zur Verstärkung (VS) des Differenzsignals unmittelbar vor dem Sigma-Delta-Modulator (SD2) vorgesehen sind.

3. Sigma-Delta-Wandler nach Anspruch 1 oder 2,
   **dadurch gekennzeichnet,**
   **dass** mindestens ein Parallel-Pfad derart ausgebildet ist, dass Mittel zur Dämpfung (D) des gewandelten Signals nach dem Mittel zur Digital-zu-Analog Wandlung (SD2) des modulierten Signals und vor der Bildung des Summensignals vorgesehen sind.

4. Sigma-Delta-Wandler nach einen der Ansprüche 1 bis 3,
   **dadurch gekennzeichnet,**
   **dass** mindestens ein Parallel-Pfad derart ausgebildet ist, dass Mittel zur zeitlichen Verzögerung (t1, t3, t5) des Eingangssignals x(k) zum Ausgleich von Laufzeitunterschieden zum Hauptpfad vorhanden sind.

5. Sigma-Delta-Wandler nach einen der Ansprüche 1 bis 4,
   **dadurch gekennzeichnet,**
   **dass** der Hauptpfad derart ausgebildet ist, dass nach der Abzweigung zum Parallel-Pfad und vor dem Mittel zur Digital-zu-Analog-Wandlung Mittel zur Kompensationsfilterung (H3') vorgesehen sind.

6. Sigma-Delta-Wandler nach einem der Ansprüche 1 bis 5,
   **dadurch gekennzeichnet,**
   **dass** der Sigma-Delta-Wandler des Haupt-Pfades als ein mehrstufiger Sigma-Delta-Wandler ($SD_M$) ausgebildet ist.

7. Sigma-Delta-Wandler nach Anspruch 6,
   **dadurch gekennzeichnet,**
   **dass** der mehrstufige Sigma-Delta-Wandler des Haupt-Pfades ($SD_M$) durch den Haupt-Pfad und mindestens eine Kaskadestufe ausgebildet ist,
   wobei jede Kaskadestufe ein Parallel-Pfad ist.

8. Sigma-Delta-Wandler nach Anspruch 7,
   **dadurch gekennzeichnet,**
   **dass** für n > 1 Kaskadestufen jede Kaskadestufe i mit $2 \leq i \leq n$, die Kaskadestufe i-1 derart parallel geschaltet ist, so dass die Kaskadestufe i-1 für die Kaskadestufe i die Funktion des Haupt-Pfades übernimmt,
   wobei dem Eingangssignal des Sigma-Delta-Modulators (SD1b, SD1c) jeder Kaskadestufe zusätzlich ein dem Hauptpfad durch Zeitverzögerung angepasstes (t2, t4) Eingangssignal x(k) aufaddiert ist,
   wobei dem Eingangssignal des Sigma-Delta-Modulators der Kaskadestufe i zusätzlich das rauschgefilterte (H1b', H1c') Signal der Kaskadestufe i-1 aufaddiert ist,
   wobei das digitale Ausgangssignal zur Differenzbildung des mehrstufigen Sigma-Delta-Modulators das Summensignal der Ausgangssignale aller Sigma-Delta-Modulatoren (SD1a, SD1b, SD1c) des mehrstufigen Sigma-Delta-Modulators ist.

9. Sigma-Delta-Wandler nach einem der Ansprüche 7 oder 8,
   **dadurch gekennzeichnet,**
   **dass** der mehrstufige Sigma-Delta-Wandler des Haupt-Pfades ($SD_M$) Sigma-Delta-Modulatoren (SD1; SD1a, SD1b, SD1c) mit linearphasigen Frequenzgängen mit Betragsfrequenzgang eins umfasst.

10. Sigma-Delta-Wandler nach Anspruch 9,
    **dadurch gekennzeichnet,**
    **dass** der mehrstufige Sigma-Delta-Wandler ($SD_M$) derart ausgebildet ist, dass eine Anzahl n > 1 Sigma-Delta-Wandler (SD1a, SD1b, SD1c) kaskadeartig parallel geschaltet sind,
    wobei das Eingangssignal des Sigma-Delta-Modulators (SD1c) der Kaskadestufe n das Differenzsignal aus dem Eingangssignal x(k) und dem rauschgefilterten (H1c') und mit n normierten Summensignal der Ausgangssignale der Sigma-Delta-Modulatoren des Hauptpfades (SD1a) und der Kaskadestufen i (SD1b) mit 1 < i < n-1 ist,
    wobei das zur Differenzbildung verwendete digitale Ausgangssignal des mehrstufigen Sigma-Delta-Modulators des Haupt-Pfades das Summensignal aller Ausgangssignale der n Sigma-Delta-Modulatoren (SD1a, SD1b, SD1c) des mehrstufigen Sigma-Delta-Modulators ($SD_M$) ist.

11. Sigma-Delta-Wandler nach Anspruch 10,
    **dadurch gekennzeichnet,**
    **dass** das Eingangssignal des Sigma-Delta-Modulators (SD1c) der Kaskadestufe n mit der Anzahl n der Kaskadestufen multipliziert ist.

12. Sigma-Delta-Wandler nach einem der Ansprüche 1 bis 11,
    **dadurch gekennzeichnet,**
    **dass** der Sigma-Delta-Wandler als 1-bit Sigma-Delta-Wandler ausgebildet ist.

13. Sigma-Delta-Wandler nach Anspruch 12,
    **dadurch gekennzeichnet,**
    **dass** der 1-bit Sigma-Delta-Wandler und damit die 1-bit Analog-zu-Digital Wandler (D/A1a, D/A1b, D/A1c, D/A2) ungleiche Ausgangsleistungen besitzen.

14. Sigma-Delta-Wandler nach einem der Ansprüche 1 bis 13,
    **dadurch gekennzeichnet**,
    die Rauschsignale der Sigma-Delta-Modulatoren des mehrstufigen Sigma-Delta-Modulators (SD1a, SD1b, SD1c) unkorreliert sind.

**15.** Sigma-Delta-Wandler nach einem der Ansprüche 1 bis 14,
**dadurch gekennzeichnet,**
**dass** den Eingangssignalen der Sigma-Delta-Modulatoren (SD1a, SD1b, SD1c) des mehrstufigen Sigma-Delta-Modulators unkorrelierte stochastische Signale (DI1a(k), DI1b(k), DI1c(k)) aufaddiert werden.

**16.** Sigma-Delta-Wandler nach einem der Ansprüche 1 bis 15,
**dadurch gekennzeichnet,**
**dass** der Sigma-Delta-Wandler in CMOS-Technik hergestellt ist.

**17.** Verwendung eines Sigma-Delta-Wandlers nach einem der vorangehenden Ansprüche in einem Funk-Kommunikationssystem, insbesondere in Funkkommunikations-Empfangseinrichtungen.

**Claims**

**1.** A sigma-delta converter for converting a digital input signal x(k) into an analogue output signal y(t) with noise suppression within a useful band,
where the sigma-delta converter comprises a principal path,
where the principal path comprises at least one sigma-delta modulator (SD1) **characterized by** a transmission function and a digital to analogue converter (D/A1),
where at least one parallel path is connected in parallel with the principal path,
where each parallel path comprises at least one sigma-delta modulator (SD2) and a digital to analogue converter (D/A2), and where the analogue output signal y(t) of the sigma-delta converter constitutes the total signal of the analogue output signals of the principal path and each parallel path,
**characterised in that**
that each parallel path is configured in such a way that the input signal of the sigma-delta modulator (SD2) in the parallel path constitutes the differential signal, filtered to exclude at least the noise components outside the useful band, resulting from the digital output signal of the sigma-delta modulator (SD1) in the principal path and the input signal x(k) which has been spectrally shaped by a filter (H2) in accordance with the transmission function of the sigma-delta modulator (SD1) in the principal path.

**2.** A sigma-delta converter according to claim 1,
**characterised in that**
at least one parallel path is configured in such a way that means for amplifying (VS) the differential signal are provided immediately before the sigma-delta modulator (SD2).

**3.** A sigma-delta converter according to claims 1 or 2,
**characterised in that**
that at least one parallel path is configured in such a way that means for attenuating (D) the converted signal are provided after the means for digital to analogue conversion (SD2) of the modulated signal and before the formation of the total signal.

**4.** A sigma-delta converter as claimed in one of claims 1 to 3,
**characterised in that**
at least one parallel path is configured in such a way that means for temporal delay (t1, t3, t5) of the input signal x(k) are present for balancing out propagation time differences with respect to the principal path.

**5.** A sigma-delta converter according to one of claims 1 to 4,
**characterised in that**
the principal path is configured in such a way that means for compensation filtering (H3') are provided after the branch to the parallel path and before the means for digital to analogue conversion.

**6.** A sigma-delta converter as claimed in one of claims 1 to 5,
**characterised in that**
the sigma-delta converter in the principal path is configured as a multi-stage sigma-delta converter ($SD_M$).

**7.** A sigma-delta converter according to claim 6,
**characterised in that**
the multi-stage sigma-delta converter in the principal path (SD$_M$) is configured by the principal path and at least one cascade stage, where each cascade stage constitutes a parallel path.

**8.** A sigma-delta converter according to claim 7,
**characterised in that**
that, for n > 1 cascade stages and each cascade stage i where $2 \leq i \leq n$, the cascade stage i-1 is connected in parallel in such a way that the cascade stage i-1 assumes the function of the principal path for the cascade stage i, where an input signal x(k) matched (t2, t4) to the principal path by means of time delay is additionally added to the input signal of the sigma-delta modulator (SD1b, SD1c) of each cascade stage, where the noise-filtered (H1b', H1c') signal of the cascade stage i-1 is additionally added to the input signal of the sigma-delta modulator of the cascade stage i, and where the digital output signal for the differential formation of the multi-stage sigma-delta modulator constitutes the total signal of the output signals of all sigma-delta modulators (SD1a, SD1b, SD1c) of the multi-stage sigma-delta modulator.

**9.** A sigma-delta converter according to one of claims 7 or 8,
**characterised in that**
that the multi-stage sigma-delta converter in the principal path (SD$_M$) comprises sigma-delta modulators (SD1; SD1a, SD1b, SD1c) with linear-phase frequency responses with an absolute frequency response of 1.

**10.** A sigma-delta converter according to claim 9,
**characterised in that**
that the multi-stage sigma-delta converter (SD$_M$) is configured in such a way that a quantity n > 1 of sigma-delta converters (SD1a, SD1b, SD1c) is connected in parallel in a cascading manner, where the input signal of the sigma-delta modulator (SD1c) of the cascade stage n constitutes the differential signal resulting from the input signal x(k)and the noise-filtered (H1c') and n-normalized total signal of the output signals of the sigma-delta modulators in the principal path (SD1a) and the cascade stages i (SD1b) where 1 < i < n-1, and where the digital output signal of the multi-stage sigma-delta modulator in the principal path used for the differential formation constitutes the total signal of all the output signals of the n sigma-delta modulators (SD1a, SD1b, SD1c) of the multi-stage sigma-delta modulator (SD$_M$).

**11.** A sigma-delta converter according to claim 10,
**characterised in that**
that the input signal of the sigma-delta modulator (SD1c) of the cascade stage n is multiplied by the quantity n of cascade stages.

**12.** A sigma-delta converter according to one of claims 1 to 11,
**characterised in that**
that the sigma-delta converter is configured as a 1-bit sigma-delta converter.

**13.** A sigma-delta converter according to claim 12,
**characterised in that**
that the 1-bit sigma-delta converter and therefore the 1-bit analogue to digital converter (D/A1a, D/A1b, D/A1c, D/A2) possess unequal output powers.

**14.** A sigma-delta converter according to one of Claims 1 to 13,
**characterised in that**
that the noise signals of the sigma-delta modulators of the multi-stage sigma-delta modulator (SD1a, SD1b, SD1c) are uncorrelated.

**15.** A sigma-delta converter according to one of claims 1 to 14,
**characterised in that**
that uncorrelated stochastic signals (DI1a(k), DI1b(k), DI1c(k)) are added to the input signals of the sigma-delta modulators (SD1a, SD1b, SD1c) of the multi-stage sigma-delta modulator.

**16.** A sigma-delta converter according to one of Claims 1 to 15,

EP 1 456 956 B1

**characterised in that**
that the sigma-delta converter is manufactured in CMOS technology.

**17.** The use of a sigma-delta converter according to one of the foregoing claims in a radio communication system, particularly in radio communication reception devices.

**Revendications**

**1.** Convertisseur Sigma-Delta pour la conversion d'un signal d'entrée x(k) numérique en un signal de sortie y(t) analogique avec suppression du bruit à l'intérieur d'une bande utile, le convertisseur Sigma-Delta comprenant un chemin principal, le chemin principal comprenant au moins un modulateur Sigma-Delta (SD1) **caractérisé par** une fonction de transfert et un convertisseur numérique-analogique (D/A1)
au moins un chemin parallèle étant branché parallèlement au chemin principal,
chaque chemin parallèle comprenant au moins un modulateur Sigma-Delta (SD2) et un convertisseur numérique-analogique (D/A2),
le signal de sortie y(t) analogique du convertisseur Sigma-Delta étant le signal composite des signaux de sortie analogiques du chemin principal et de chaque chemin parallèle,
**caractérisé en ce que**
chaque chemin parallèle est conçu de telle sorte que le signal d'entrée du modulateur Sigma-Delta (SD2) du chemin parallèle est le signal différentiel, filtré au moins des parties de bruit à l'extérieur de la bande utile, constituée du signal de sortie numérique du modulateur Sigma-Delta (SD1) du chemin principal et du signal d'entrée x(k) mis en forme au niveau spectral conformément à la fonction de transfert du modulateur Sigma-Delta (SD1) du chemin principal par un filtre (H2).

**2.** Convertisseur Sigma-Delta selon la revendication 1,
**caractérisé en ce que**
au moins un chemin parallèle est conçu de telle sorte que des moyens sont prévus pour l'amplification (VS) du signal différentiel juste avant le modulateur Sigma-Delta (SD2).

**3.** Convertisseur Sigma-Delta selon la revendication 1 ou 2,
**caractérisé en ce que**
au moins un chemin parallèle est conçu de telle sorte que des moyens sont prévus pour l'amortissement (D) du signal converti après le moyen pour la conversion numérique-analogique (SD2) du signal modulé et avant la formation du signal composite.

**4.** Convertisseur Sigma-Delta selon l'une quelconque des revendications 1 à 3,
**caractérisé en ce que**
au moins un chemin parallèle est conçu de telle sorte que des moyens existent pour le retard dans le temps (t1, t3, t5) du signal d'entrée x(k) pour la compensation de différences de temps de propagation par rapport au chemin principal.

**5.** Convertisseur Sigma-Delta selon l'une quelconque des revendications 1 à 4,
**caractérisé en ce que**
le chemin principal est conçu de telle sorte que des moyens pour le filtrage de compensation (H3') sont prévus après la dérivation vers le chemin parallèle et avant le moyen pour la conversion numérique-analogique.

**6.** Convertisseur Sigma-Delta selon l'une quelconque des revendications 1 à 5,
**caractérisé en ce que**
le convertisseur Sigma-Delta du chemin principal est conçu comme un convertisseur Sigma-Delta (SD$_M$) à plusieurs niveaux.

**7.** Convertisseur Sigma-Delta selon la revendication 6,
**caractérisé en ce que**
le convertisseur Sigma-Delta à plusieurs niveaux du chemin principal (SD$_M$) est conçu par le chemin principal et au moins un niveau en cascade, chaque niveau en cascade étant un chemin parallèle.

**8.** Convertisseur Sigma-Delta selon la revendication 7,

**11**

**caractérisé en ce que**

pour n > 1 niveaux de cascade chaque niveau de cascade i avec 2 ≤ i ≤ n, le niveau de cascade i-1 est branché parallèlement de telle sorte que le niveau de cascade i-1 assume la fonction du chemin principal pour le niveau de cascade i,

en supplément un signal d'entrée x(k) adapté au chemin principal par temporisation étant ajouté au signal d'entrée du modulateur Sigma-Delta (SD1b, SD1c) de chaque niveau de cascade,

en supplément le signal, filtré au niveau du bruit (H1b', H1c'), du niveau de cascade i-1 étant ajouté au signal d'entrée du modulateur Sigma-Delta du niveau de cascade i,

le signal de sortie numérique pour la formation de différence du modulateur Sigma-Delta à plusieurs niveaux étant le signal composite des signaux de sortie de tous les modulateurs Sigma-Delta (SD1a, SD1b, SD1c) du modulateur Sigma-Delta à plusieurs niveaux.

9. Convertisseur Sigma-Delta selon l'une quelconque des revendications 7 ou 8,
   **caractérisé en ce que**
   le convertisseur Sigma-Delta à plusieurs niveaux du chemin principal ($SD_M$) comprend les modulateurs Sigma-Delta (SD1 ; SD1a, SD1b, SD1c) avec des courbes de fréquence à phase linéaire avec une courbe de fréquence de valeur 1.

10. Convertisseur Sigma-Delta selon la revendication 9,
    **caractérisé en ce que**
    le convertisseur Sigma-Delta ($SD_M$) à plusieurs niveaux est conçu de telle sorte qu'un nombre n > 1 de convertisseurs Sigma-Delta (SD1a, SD1b, SD1c) sont montés parallèlement à la façon d'une cascade,
    le signal d'entrée du modulateur Sigma-Delta (SD1c) du niveau de cascade n est le signal différentiel constitué du signal d'entrée x(k) et du signal composite, filtré au niveau du bruit (H1c') et normalisé avec n, des signaux de sortie des modulateurs Sigma-Delta du chemin principal (SD1a) et des niveaux de cascade i (SD1b) avec 1 < i < n-1,
    le signal de sortie numérique, utilisé pour la formation de différence, du modulateur Sigma-Delta à plusieurs niveaux du chemin principal est le signal composite de tous les signaux de sortie des n modulateurs Sigma-Delta (SD1a, SD1b, SD1c) du modulateur Sigma-Delta à plusieurs niveaux ($SD_M$).

11. Convertisseur Sigma-Delta selon la revendication 10,
    **caractérisé en ce que**
    le signal d'entrée du modulateur Sigma-Delta (SD1c) du niveau de cascade n est multiplié par le nombre n des niveaux de cascade.

12. Convertisseur Sigma-Delta selon l'une quelconque des revendications 1 à 11,
    **caractérisé en ce que**
    le convertisseur Sigma-Delta est conçu comme un convertisseur Sigma-Delta de 1 bit.

13. Convertisseur Sigma-Delta selon la revendication 12,
    **caractérisé en ce que**
    le convertisseur Sigma-Delta de 1 bit et donc les convertisseurs analogique-numérique de 1 bit (D/A1a, D/A1b, D/A1c, D/A2) présentent des puissances de sortie inégales.

14. Convertisseur Sigma-Delta selon l'une quelconque des revendications 1 à 13,
    **caractérisé en ce que**
    les signaux de bruit des modulateurs Sigma-Delta du modulateur Sigma-Delta à plusieurs niveaux (SD1a, SD1b, SD1c) ne sont pas corrélés.

15. Convertisseur Sigma-Delta selon l'une quelconque des revendications 1 à 14,
    **caractérisé en ce que**
    des signaux stochastiques non corrélés (DI1a (k), DI1b (k), DIlc (k)) sont ajoutés aux signaux d'entrée des modulateurs Sigma-Delta (SD1a, SD1b, SD1c) du modulateur Sigma-Delta à plusieurs niveaux.

16. Convertisseur Sigma-Delta selon l'une quelconque des revendications 1 à 15,
    **caractérisé en ce que**
    le convertisseur Sigma-Delta est fabriqué dans une technique CMOS.

17. Utilisation d'un convertisseur Sigma-Delta selon l'une quelconque des revendications précédentes dans un système de radiocommunication, en particulier dans des dispositifs de réception de radiocommunication.

Fig. 1

Fig. 2

Fig. 3

EP 1 456 956 B1

Fig. 4